# EUROPEAN PATENT APPLICATION

(11) **EP 2 284 902 A1**
(43) Date of publication of application: **16.02.2011**
(21) Application number: 09746429.1
(22) Date of filing: 12.03.2009
(51) Int. Cl.: H01L 31/0224, H01L 31/068

(54) **SOLAR BATTERY AND SOLAR BATTERY MANUFACTURING METHOD**

(30) Priority: 14.05.2008 JP 2008127497
(71) Applicant: Sharp Kabushiki Kaisha, Osaka-shi, Osaka 545-8522 (JP)
(72) Inventor: YAMAMOTO, Shinya, Osaka-shi, Osaka 545-8522 (JP); TANAKA, Satoshi, Osaka-shi, Osaka 545-8522 (JP); MACHIDA, Tomohiro, Osaka-shi, Osaka 545-8522 (JP)
(74) Representative: Müller - Hoffmann & Partner
(86) International application number: PCT/JP2009/054731
(87) International publication number: WO 2009/139222

(57) **Abstract**

A solar cell including a semiconductor substrate (1) having a pn junction, a silver electrode (4) and an aluminum electrode (5) on a rear surface of the semiconductor substrate (1), and an overlap region (9) where the silver electrode (4) and the aluminum electrode (5) overlap each other, a glass softening point temperature of a glass component contained in the silver electrode (4) being equal to or higher than a glass softening point temperature of a glass component contained in the aluminum electrode (5), and a method of manufacturing the solar cell are provided.

## Description

### TECHNICAL FIELD

The present invention relates to a solar cell and a method of manufacturing a solar cell, and more particularly to a solar cell capable of achieving excellent electrical characteristics and reliability of a solar cell module while keeping manufacturing costs low and a method of manufacturing the solar cell.

### BACKGROUND ART

In recent years, development of clean energy has been desired against the backdrop of global environmental problems such as exhaustion of energy resources and increase in CO₂ in the atmosphere, and solar power generation using solar cells, particularly, has been developed and practically utilized as a new energy source, making continued progress.

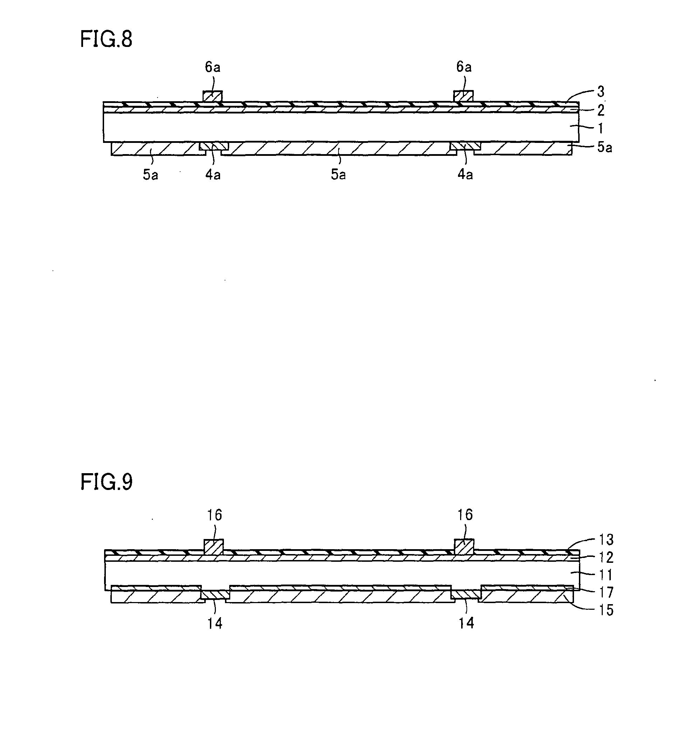

Fig. 9 shows a schematic cross-sectional view of a conventional and common solar cell. As shown in Fig. 9, in a conventional solar cell, an n+ layer 12 is formed in a light-receiving surface of a p type silicon substrate 11, with an antireflection coating 13 and a silver electrode 16 being formed on n+ layer 12. A p+ layer 17 is formed in a portion of a rear surface of silicon substrate 11, with an aluminum electrode 15 being formed on p+ layer 17. A silver electrode 14 is formed in a region other than a region where p+ layer 17 is formed on the rear surface of silicon substrate 11.

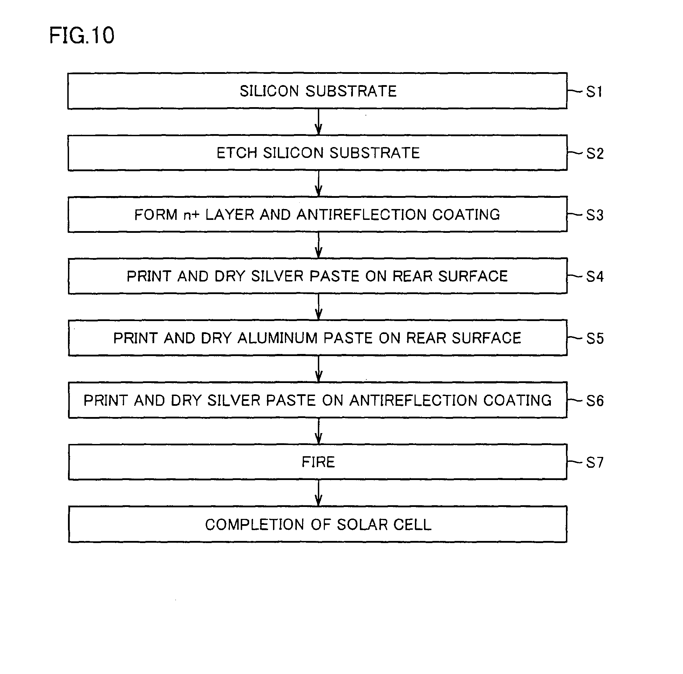

Fig. 10 shows a flowchart of an exemplary method of manufacturing a conventional solar cell having the structure shown in Fig. 9. First, as shown in step S1, p type silicon substrate 11 is prepared. Next, as shown in step S2, a surface of silicon substrate 11 is etched to remove a damaged layer and the like.

Next, as shown in step S3, n+ layer 12 is formed by diffusion of an n type dopant into one surface serving as the light-receiving surface of silicon substrate 11, and antireflection coating 13 is formed on n+ layer 12.

Next, as shown in step S4, a silver paste is printed by screen printing on the rear surface of silicon substrate 11 opposite to the light-receiving surface, and dried at a temperature of about 150°C to 200°C.

Next, as shown in step S5, an aluminum paste is printed by screen printing on substantially the entire portion other than a portion where the silver paste was printed on the rear surface of silicon substrate 11, and dried at a temperature of about 150°C to 200°C. Here, the aluminum paste is printed with overlap over the silver paste.

Next, as shown in step S6, a silver paste is printed in a pattern by screen printing on antireflection coating 13 on the light-receiving surface of silicon substrate 11, and dried at a temperature of about 150°C to 200°C.

Next, as shown in step S7, the silver paste on the light-receiving surface side of silicon substrate 11 and the silver paste and the aluminum paste on the rear surface side of silicon substrate 11 are fired at 700 to 750°C, to form silver electrode 16 on the light-receiving surface side of silicon substrate 11, and form silver electrode 14 and aluminum electrode 15 on the rear surface of silicon substrate 11.

The aluminum paste acts as a p type dopant during the firing stated above to form p+ layer 17 as well in the rear surface of silicon substrate 11, which contributes significantly to improvement in electrical characteristics of the solar cell. Consequently, a conventional solar cell having the structure shown in Fig. 9 is completed.

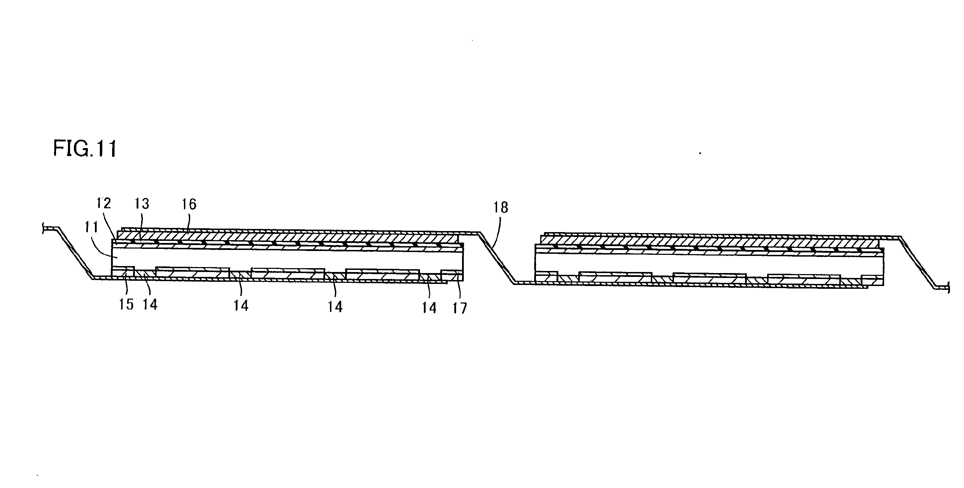

Fig. 11 shows a schematic cross-sectional view of a solar cell with an interconnector, which is formed by connecting an interconnector to the conventional solar cell having the structure shown in Fig. 9 manufactured as above. The solar cell with the interconnector having the structure shown in Fig. 11 can be formed by preparing a plurality of the conventional solar cells manufactured as above, setting one end of an interconnector 18 on silver electrode 16 on a light-receiving surface side of one of the solar cells and the other end of interconnector 18 on silver electrode 14 on a rear surface side of another solar cell, applying a flux to interconnector 18, silver electrode 14 and silver electrode 16, and heating them while keeping them in close contact with one another.

A plurality of the solar cells with the interconnector each having the structure shown in Fig. 11 are manufactured, and then the plurality of the solar cells with the interconnector are connected in series or in parallel, to manufacture a solar cell module.

Although a solar cell manufactured with a method of firing a silver paste on a light-receiving surface side of a silicon substrate and a silver paste and an aluminum paste on a rear surface side simultaneously has become predominant in recent years, a method of firing a silver paste on a light-receiving surface side of a silicon substrate and a silver paste and an aluminum paste on a rear surface side individually has also been conventionally employed.

Conventionally, an interconnector would be connected after solder coating has been applied to a solar cell. In recent years, a method without application of solder coating to a solar cell as stated above has become predominant. When this method is employed, solder coated on a surface of an interconnector is utilized.
Patent Document 1: Japanese Patent Laying-Open No. 2001-127317
Patent Document 2: Japanese Patent Laying-Open No. 2006-351530

### DISCLOSURE OF THE INVENTION

### PROBLEMS TO BE SOLVED BY THE INVENTION

In the solar cell industry which has particularly been attracting attention in recent years, a technology of improving electrical characteristics of a solar cell without sacrificing reliability of the solar cell has been desired. In addition, with intensified sales competition becoming very pronounced along with growth in production volume of solar cells in recent years, it is desired to introduce a solar cell having excellent electrical characteristics as well as achieving excellent cost performance to the market.

In general, electrical characteristics of a solar cell and a solar cell module often depend on quantity of electrical resistance. Particularly, a fill factor (F.F.) largely depends on quantity of electrical resistance which is based on compositions of silver pastes acting as precursors of silver electrodes and a composition of an aluminum paste acting as a precursor of an aluminum electrode that are formed on opposing surfaces of a solar cell, or a combination thereof, and further based on electrical connection between the silver electrodes and an interconnector, with much depending on the compositions and properties of the silver pastes.

A silver paste is commonly composed of silver particles, a glass component such as a glass frit, an organic binder such as resin and a vehicle, an inorganic additive, an organic solvent, and the like. Silver pastes printed on a light-receiving surface and a rear surface of a silicon substrate, respectively, are largely similar in composition to each other such as ability to allow use of screen printing suitable for mass production. However, a silver paste printed on a light-receiving surface of a silicon substrate and a silver paste printed on a rear surface are different in composition from each other due to the difference in functionality that should be provided to the silver pastes.

In order to lower electrical resistance of a silver electrode itself after firing, it is desirable to increase a blend ratio of silver particles regardless of whether it is a light-receiving surface or a rear surface of a silicon substrate. Simply increasing the blend ratio of silver particles, however, causes decrease in blend ratio of a glass component in a silver paste, and when such trend becomes excessive, adhesive strength between the silicon substrate and the silver electrode becomes deteriorated. It is also readily understood that a higher blend ratio of silver particles involves further additional material costs.

A glass component in a silver paste tends to be localized in the vicinity of a surface of an electrode after the firing process as stated above. The localization of a glass component in an electrode surface on a light-receiving surface side of a silicon substrate acts to improve adhesive strength between the silicon substrate and the silver electrode, while the localization of a glass component in an electrode surface on a side opposite to the silicon substrate acts to deteriorate attachability of an interconnector to the silver electrode in a subsequent step.

That is, decrease in blend ratio of a glass component in a silver paste generally leads to improved attachability of an interconnector, while resulting in lowered adhesive strength between a silicon substrate and a silver electrode. On the other hand, increase in blend ratio of a glass component in a silver paste leads to improved adhesive strength between a silicon substrate and a silver electrode, while resulting in deteriorated attachability of an interconnector.

If a firing temperature is increased in order to improve adhesive strength between a silicon substrate and a silver electrode, the localization of a glass component in an electrode surface is facilitated, resulting in deteriorated attachability of an interconnector. Moreover, lowering of adhesive strength between a silicon substrate and a silver electrode and deterioration of attachability of an interconnector directly causes poor electrical contact in those portions, which adversely affects electrical characteristics and reliability of a solar cell module as well.

Particularly, when a composition of a silver paste for forming a silver electrode on a rear surface is determined, it is required to improve electrical characteristics of a solar cell and a solar cell module by lowering electrical resistance of the silver electrode itself as well as electrical resistance generated in a region where the silver electrode and an aluminum electrode overlap each other, to improve adhesive strength between a silicon substrate and the silver electrode, and to improve attachability of an interconnector, thereby not compromising reliability of a solar cell module.

A silver paste and an aluminum paste each contain a glass component as stated above. Adaptability of a glass component to a solar cell in terms of characteristics such as a composition and a softening point has been determined based on evaluation of a silver paste or an aluminum paste (Japanese Patent Laying-Open No. 2001-127317, Japanese Patent Laying-Open No. 2006-351530). According to those results, it has been found that glass components of a silver paste and an aluminum paste have no correlation to each other and are different in composition and property from each other in most cases, which contributes to increase in electrical resistance in a rear surface of a solar cell having both a silver electrode and an aluminum electrode.

In view of the circumstances stated above, an object of the present invention is to provide a solar cell capable of achieving excellent electrical characteristics and reliability of a solar cell module while keeping manufacturing costs low and a method of manufacturing the solar cell.

### MEANS FOR SOLVING THE PROBLEMS

The present invention is directed to a solar cell including a semiconductor substrate having a pn junction, a silver electrode and an aluminum electrode on a rear surface of the semiconductor substrate, and an overlap region where the silver electrode and the aluminum electrode overlap each other, a glass softening point temperature of a glass component contained in the silver electrode being equal to or higher than a glass softening point temperature of a glass component contained in the aluminum electrode.

The present invention is also directed to a method of manufacturing the solar cell stated above, including the steps of applying a silver paste acting as a precursor of the silver electrode to the rear surface of the semiconductor substrate, applying an aluminum paste acting as a precursor of the aluminum electrode to the rear surface of the semiconductor substrate, and firing the silver paste and the aluminum paste, a glass softening point temperature of a glass component contained in the silver paste being equal to or higher than a glass softening point temperature of a glass component contained in the aluminum paste.

### EFFECTS OF THE INVENTION

According to the present invention, a solar cell capable of achieving excellent electrical characteristics and reliability of a solar cell module while keeping manufacturing costs low and a method of manufacturing the solar cell can be provided.

### BRIEF DESCRIPTION OF THE DRAWINGS

Fig. 1 is a schematic cross-sectional view of an exemplary solar cell according to the present invention.
Fig. 2 is a schematic plan view of a rear surface of the solar cell having the structure shown in Fig. 1.
Fig. 3 is a schematic cross-sectional view illustrating a portion of a manufacturing process of an exemplary method of manufacturing the solar cell having the structure shown in Fig. 1.
Fig. 4 is a schematic cross-sectional view illustrating another portion of the manufacturing process of the exemplary method of manufacturing the solar cell having the structure shown in Fig. 1.
Fig. 5 is a schematic cross-sectional view illustrating another portion of the manufacturing process of the exemplary method of manufacturing the solar cell having the structure shown in Fig. 1.
Fig. 6 is a schematic cross-sectional view illustrating another portion of the manufacturing process of the exemplary method of manufacturing the solar cell having the structure shown in Fig. 1.
Fig. 7 is a schematic cross-sectional view illustrating another portion of the manufacturing process of the exemplary method of manufacturing the solar cell having the structure shown in Fig. 1.
Fig. 8 is a schematic cross-sectional view illustrating another portion of the manufacturing process of the exemplary method of manufacturing the solar cell having the structure shown in Fig. 1.
Fig. 9 is a schematic cross-sectional view of a conventional and common solar cell.
Fig. 10 is a flowchart of an exemplary method of manufacturing the conventional solar cell having the structure shown in Fig. 9.
Fig. 11 is a schematic cross-sectional view of a solar cell with an interconnector, which is formed by connecting an interconnector to the conventional solar cell having the structure shown in Fig. 9.

### DESCRIPTION OF THE REFERENCE SIGNS

1, 11 silicon substrate; 2, 12 n+ layer; 3, 13 antireflection coating; 4, 6, 14, 16 silver electrode; 4a, 6a silver paste; 5, 15 aluminum electrode; 5a aluminum paste; 7, 17 p+ layer; 9 overlap region; 10 exposed region; 18 interconnector.

### BEST MODES FOR CARRYING OUT THE INVENTION

An embodiment of the present invention will be described below. It is noted that the same or corresponding parts have the same reference signs allotted in the drawings of the present invention. In the present invention, when used as a solar cell, a surface of a semiconductor substrate sunlight mainly enters is referred to as a light-receiving surface, and a surface of the semiconductor substrate opposite to the light-receiving surface is referred to as a rear surface.

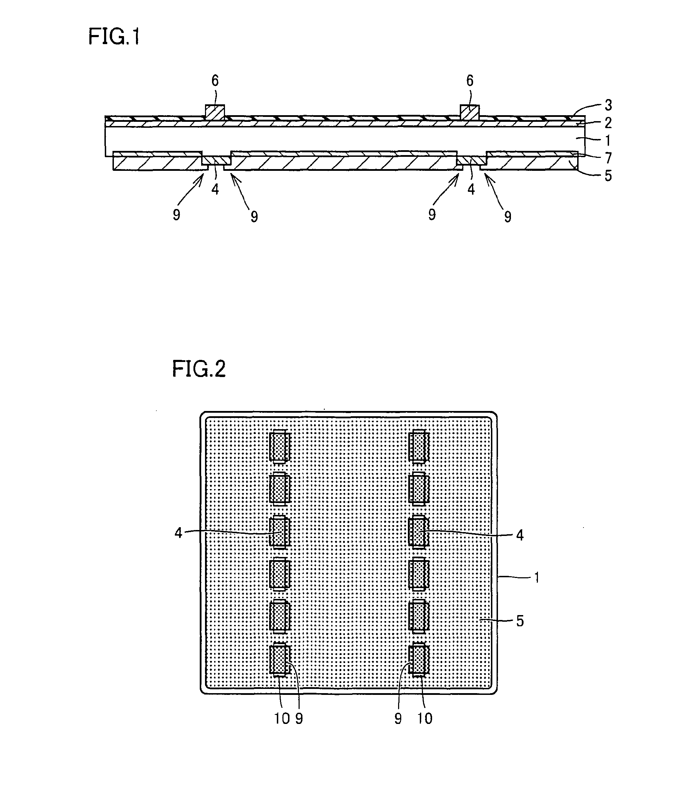

Fig. 1 shows a schematic cross-sectional view of an exemplary solar cell according to the present invention. In the solar cell having the structure shown in Fig. 1, an n+ layer 2 is formed in a light-receiving surface of a semiconductor substrate 1 formed from a p type silicon substrate, for example, and a p+ layer 7 is formed in a portion of a rear surface of semiconductor substrate 1 opposite to the light-receiving surface. In this example where semiconductor substrate 1 is of p type and n+ layer 2 is of n type, a pn junction (junction between a p type semiconductor and an n type semiconductor) is formed at an interface between an inner region of p type of semiconductor substrate 1 and n+ layer 2 of n type. The present invention, however, is not limited to this configuration.

An antireflection coating 3 and a silver electrode 6 are formed on n+ layer 2 in the light-receiving surface of semiconductor substrate 1. An aluminum electrode 5 is formed on p+ layer 7 in the rear surface of semiconductor substrate 1, and a silver electrode 4 is formed in a region where p+ layer 7 is not formed on the rear surface of semiconductor substrate 1. An overlap region 9 where silver electrode 4 and aluminum electrode 5 overlap each other is formed on the rear surface of semiconductor substrate 1.

Fig. 2 shows a schematic plan view of the rear surface of the solar cell having the structure shown in Fig. 1. Aluminum electrode 5 is formed on substantially the entire rear surface of semiconductor substrate 1 of the solar cell, and silver electrode 4 is formed in an island shape.

In a longitudinal direction of silver electrode 4, an exposed region 10 where no electrode is formed and through which the rear surface of semiconductor substrate 1 is exposed is formed between silver electrode 4 and aluminum electrode 5. Overlap region 9 stated above is formed in a direction orthogonal to the longitudinal direction of silver electrode 4.

As will be described later, for example, silver electrode 4 on the rear surface of semiconductor substrate 1 is formed by firing a silver paste containing silver particles and a glass component, and aluminum electrode 5 is formed by firing an aluminum paste containing aluminum particles and a glass component. Thus, silver electrode 4 and aluminum electrode 5 each contain a glass component such as a glass frit. In the present invention, a glass softening point temperature of the glass component contained in silver electrode 4 is equal to or higher than a glass softening point temperature of the glass component contained in aluminum electrode 5 (namely, the glass softening point temperature of the glass component contained in silver electrode 4 is identical to or above the glass softening point temperature of the glass component contained in aluminum electrode 5).

Overlap region 9 where silver electrode 4 and aluminum electrode 5 overlap each other on the rear surface of the solar cell is necessary in order to establish electrical contact between silver electrode 4 and aluminum electrode 5. In overlap region 9 which is increased in temperature in a firing step, an alloy mainly containing silver and aluminum is formed, and the alloy causes electrical resistance.

Thus, in overlap region 9, increase in this electrical resistance causes F.F. loss of the solar cell. Nonetheless, by selecting a glass component having a higher glass softening point temperature as a glass component contained in a silver paste as in the present invention, electrical resistance in overlap region 9 can be lowered without increasing a blend ratio of silver particles in the silver paste, which leads to excellent electrical characteristics and reliability of a solar cell module after attachment of an interconnector. In addition, since increase in blend ratio of silver particles in the silver paste can be suppressed, an amount of expensive silver particles used can be suppressed, so that manufacturing costs of the solar cell and the solar cell module can be kept low.

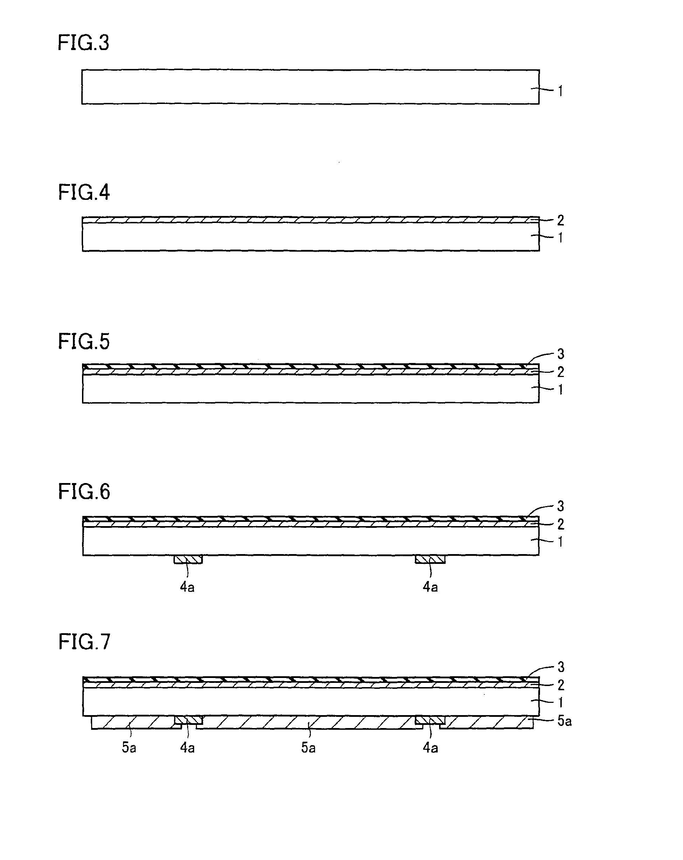

Referring to schematic cross-sectional views in Figs. 3 to 8, an exemplary method of manufacturing the solar cell having the structure shown in Fig. 1 is described.

First, as shown in Fig. 3, semiconductor substrate 1 is prepared. Although this example employs a p type silicon substrate as semiconductor substrate 1, a semiconductor substrate used in the present invention is of course not limited to a p type silicon substrate.

Next, as shown in Fig. 4, n+ layer 2 is formed in one surface of semiconductor substrate 1. N+ layer 2 can be formed by thermal diffusion of an n type dopant such as phosphorus, for example.

Next, as shown in Fig. 5, antireflection coating 3 is formed on n+ layer 2 in semiconductor substrate 1. Antireflection coating 3 can be formed from a silicon nitride film, for example, and can be formed by plasma CVD, for example.

Next, as shown in Fig. 6, a silver paste 4a is applied to a surface of semiconductor substrate 1 opposite to the surface in which n+ layer 2 was formed. Silver paste 4a can be applied by screen printing, for example.

Silver paste 4a may contain silver particles, a glass component, an organic binder, and an organic solvent, for example. A glass softening point temperature of the glass component contained in silver paste 4a is equal to or higher than a glass softening point temperature of a glass component contained in an aluminum paste 5a which will be described later.

The silver particle is not particularly limited, and silver particles known in the field of solar cells can be used. The silver particle may be in a spherical shape, a flake-like shape, or a needle-like shape, for example. An average particle dimension of the silver particle is, from the viewpoint of improving workability, preferably not less than 0.05 µm but not more than 10 µm, and more preferably not less than 0.1 µm but not more than 5 µm. The average particle dimension of the silver particle as used herein refers to an average value of a particle size if the silver particle is in a spherical shape, and refers to an average value of a major axis of the silver particle (maximum length of a line segment connecting arbitrary two points to each other on an external surface of the silver particle) if the silver particle is in a flake-like shape or a needle-like shape.

The glass component is not particularly limited, as long as it has a glass softening point temperature equal to or higher than the glass softening point temperature of the glass component contained in aluminum paste 5a which will be described later. For example, a conventionally known glass frit such as a B₂O₃-SiO₂-PbO-based, SiO₂-Bi₂O₃-PbO-based, B₂O₃-SiO₂-Bi₂O₃-based, B₂O₃-SiO₂-PbO-ZnO-based, or B₂O₃-SiO₂-ZnO-based glass frit can be used.

It is preferable to use a glass component having a glass softening point temperature of not more than 650°C, and more preferable to use a glass component having a glass softening point temperature of not more than 600°C, as the glass component of silver paste 4a. If the glass softening point temperature of the glass component of silver paste 4a is not more than 650°C, particularly not more than 600°C, attachability of an interconnector to the silver electrode after firing which will be described later tends to be improved, which in turn tends to improve the electrical characteristics and reliability of the solar cell module.

In the present invention, a glass softening point temperature refers to a softening point measured in accordance with the specifications of JIS R3103-01:2001, "Viscosity and viscometric fixed points of glass-Part 1: Determination of softening point."

The organic binder is not particularly limited, either, and a conventionally known organic binder may be used. For example, at least one type of cellulosic resin such as ethyl cellulose, nitrocellulose, and (metha)acrylic resin such as polymethyl acrylate, polymethyl methacrylate can be used.

The organic solvent is not particularly limited, either, and a conventionally known organic solvent may be used. For example, at least one type of alcohols such as terpineol (α-terpineol, β-terpineol or the like), and esters such as hidroxy group-containing esters (2,2,4-trimethyl-1,3-pentanediol monoisobutyrate, butyl carbitol acetate, or the like) can be used.

Silver paste 4a may of course contain a component other than the silver particles, the glass component, the organic binder and the organic solvent stated above.

Next, as shown in Fig. 7, aluminum paste 5a is applied to the surface of semiconductor substrate 1 on the side where silver paste 4a was applied, with overlap over silver paste 4a. Aluminum paste 5a can be applied by screen printing, for example. Aluminum paste 5a is applied to overlap silver paste 4a.

Aluminum paste 5a may contain aluminum particles, a glass component, an organic binder, and an organic solvent, for example.

The aluminum particle is not particularly limited, and aluminum particles known in the field of solar cells can be used. The aluminum particle may be in a spherical shape, a flake-like shape, or a needle-like shape, for example. An average particle dimension of the aluminum particle is, from the viewpoint of ensuring reactivity with semiconductor substrate 1 formed from a p type silicon substrate, application property and application uniformity of aluminum paste 5a, preferably not less than 2 µm but not more than 20 µm. The average particle dimension of the aluminum particle as used herein refers to an average value of a particle size if the aluminum particle is in a spherical shape, and refers to an average value of a major axis of the aluminum particle (maximum length of a line segment connecting arbitrary two points to each other on an external surface of the aluminum particle) if the aluminum particle is in a flake-like shape or a needle-like shape.

Descriptions of the glass component, the organic binder and the organic solvent in aluminum paste 5a are the same as the descriptions of those in silver paste 4a stated above.

Aluminum paste 5a may also of course contain a component other than the aluminum paste particles, the glass component, the organic binder and the organic solvent stated above.

Next, as shown in Fig. 8, a silver paste 6a is applied to antireflection coating 3 of semiconductor substrate 1. Silver paste 6a can be applied by screen printing, for example.

Silver paste 6a may contain silver particles, a glass component, an organic binder, and an organic solvent, for example.

Descriptions of the silver particles, the glass component, the organic binder and the organic solvent in silver paste 6a are the same as the descriptions of those in silver paste 4a stated above.

Silver paste 6a may also of course contain a component other than the silver particles, the glass component, the organic binder and the organic solvent stated above.

Although silver paste 4a, aluminum paste 5a and silver paste 6a are applied in this order in the above description, the order of application is of course not limited as such.

Thereafter, silver paste 6a applied to one surface of semiconductor substrate 1 and silver paste 4a and aluminum paste 5a applied to the other surface of semiconductor substrate 1 are fired. This causes silver paste 6a to fire through antireflection coating 3 to contact n+ layer 2, to become silver electrode 6 shown in Fig. 1, and silver paste 4a and aluminum paste 5a become silver electrode 4 and aluminum electrode 5 shown in Fig. 1, respectively. Consequently, the solar cell having the structure shown in Fig. 1 can be manufactured.

Silver paste 6a on one surface of semiconductor substrate 1 and silver paste 4a and aluminum paste 5a on the other surface of semiconductor substrate 1 may be fired simultaneously, or may be partially fired simultaneously, or may be fired individually.

If silver paste 6a, silver paste 4a and aluminum paste 5a are fired individually, for example, the order of firing is not particularly limited.

In recent years, speeding up in a firing condition has been promoted due to request for production increase from the market. That is, a conventional firing condition has been a peak temperature of 600°C/about 3 mm per second, for example, while a recent firing condition has been enhanced in speed to a peak temperature of 750°C/about 5 mm per second.

Therefore, under a high temperature condition having a peak temperature of 750°C during firing like the recent firing condition, even a glass component having a high softening point can be completely melted.

On the other hand, under a low temperature condition having a peak temperature of 600°C like the conventional firing condition, a glass component having a high softening point is not completely melted, resulting in both a melted portion and an unmelted portion. Thus, use of a glass component having a high softening point has been conventionally unsuitable.

When a glass component contained in a silver paste is fired, the glass component has the property of being localized in the vicinity of a surface of the silver paste. If a silver paste containing a glass component having a high softening point is fired under the recent firing condition having a peak temperature of 750°C stated above, however, the glass component gradually appears on a surface of the silver paste, and thus appears in the form of a partial film or in spots without becoming a complete film.

When the glass component appears in the form of a partial film or in spots, contact between silver electrode 4 and aluminum electrode 5 in overlap region 9 is less likely to be prevented by the glass component, which leads to more direct contact between them. Accordingly, contact resistance between silver electrode 4 and aluminum electrode 5 can be lowered, which leads to excellent electrical characteristics and reliability of the solar cell module.

### Examples

### <Fabrication of Solar Cells in Examples 1 to 4 and Comparative Examples 1 to 4>

First, in one surface of a p type silicon substrate etched by acid having a thickness of 180 µm and having a square surface 156 mm per side, an n+ layer having a surface resistance value of about 50 Ω/□ was formed by thermal diffusion of phosphorus as an n type dopant at about 800°C to 900°C, and a silicon nitride film having a thickness of about 70 to 100 nm was formed on the n+ layer by plasma CVD as an antireflection coating.

Then, silver pastes were made which contained spherical silver particles having an average particle dimension of 0.4 µm blended in percents by mass indicated in the column of Blend ratio of silver particles in silver paste in Table 1 below, respectively.

The silver pastes were made by mixing the silver particles stated above, ethyl cellulose as an organic binder, 2,2,4-trimethyl-1,3-pentanediol monoisobutyrate as an organic solvent, and glass components indicated in the column of Composition of glass component in Table 1 below. The silver pastes were made such that a mass of ethyl cellulose : a mass of 2,2,4-trimethyl-1,3-pentanediol monoisobutyrate : a mass of glass component = 3:13:2.

A glass component A was a B₂O₃-SiO₂-PbO-based glass frit, and a glass component B was a B₂O₃-SiO₂-PbO-ZnO-based glass frit. Adjustments were made such that their glass softening point temperatures attain to values shown in Table 1.

The glass softening point temperatures of the glass components shown in Table 1 were measured in accordance with the specifications of JIS R3103-01:2001, "Viscosity and viscometric fixed points of glass-Part 1: Determination of softening point."

In examples 1 to 4 and comparative example 1, a blend ratio of glass component A was 1.42% by mass. A blend ratio of glass component B in comparative examples 2 to 3 was 1.42% by mass, and a blend ratio of glass component B in comparative example 4 was not less than 3% by mass.

Then, each of the silver pastes made as stated above was screen printed in a portion of the other surface serving as a rear surface of the p type silicon substrate, and dried by heating to about 150°C.

Next, a commercially available aluminum paste containing a glass component having a glass softening point temperature of 505°C was printed by screen printing on substantially the entire surface serving as the rear surface of the p type silicon substrate with overlap over the silver paste, and dried at about 150°C.

Thereafter, a prescribed silver paste was printed by screen printing in a portion of the one surface serving as a light-receiving surface of the p type silicon substrate, and dried at about 150°C.

Then, the silver paste and the aluminum paste on the rear surface of the p type silicon substrate and the silver paste on the light-receiving surface of the p type silicon substrate were fired at about 740°C in the air, to form a silver electrode on the light-receiving surface of the p type silicon substrate, and form a p+ layer in the rear surface of the p type silicon substrate as well as a silver electrode and an aluminum electrode on the rear surface of the p type silicon substrate, to complete a solar cell.

The solar cells in examples 1 to 4 and comparative examples 1 to 4 were fabricated by performing the fabrication process of the solar cell stated above under the same conditions and by the same method, except that the silver pastes shown in examples 1 to 4 and comparative examples 1 to 4 in Table 1 below were used, respectively.

### <Method of Evaluating Solar Cells in Examples 1 to 4 and Comparative Examples 1 to 4>

### (i) Electrical Resistance in Overlap Region of Silver Electrode-Aluminum Electrode on Rear Surface

Electrical resistance in the overlap region of the silver electrode-the aluminum electrode on the rear surface of the solar cell in each of examples 1 to 4 and comparative examples 1 to 4 was determined by subtracting electrical resistance of the aluminum electrode between the silver electrodes on the rear surface from electrical resistance between the silver electrodes in the same distance. The results are shown in Table 1.

Note that values indicated in the column of Electrical resistance in overlap region of silver electrode-aluminum electrode on rear surface in Table 1 are expressed in relative value (%) based on the assumption that electrical resistance in the overlap region of the silver electrode and the aluminum electrode on the rear surface of the solar cell in comparative example 4 is 100%. In addition, these values of electrical resistance are average values based on measurement of 4 to 6 solar cells.

### (ii) F.F. Loss After Attachment of Interconnector

A current-voltage characteristic of the solar cell in each of examples 1 to 4 and comparative examples 1 to 4 fabricated as stated above was measured with light from a solar simulator (AM1.5, energy density of 100 mW/cm²), and a F. F. before attachment of an interconnector was calculated based on the measurement result.

Next, a commercially available flux was applied to the silver electrode on the rear surface of the solar cell in each of examples 1 to 4 and comparative examples 1 to 4, and to an interconnector having a thickness of 0.2 mm and a width of 2 mm coated with solder, and a soldering iron heated to about 400°C was used to attach an interconnector made of copper to the silver electrode on the rear surface of the solar cell in each of examples 1 to 4 and comparative examples 1 to 4. After attachment of the interconnector, a F. F. after attachment of the interconnector was calculated in a manner similar to the above method, and F.F. loss after attachment of the interconnector was calculated by calculating the difference between the F.F. before attachment of the interconnector calculated as stated above and the F.F. after attachment of the interconnector. The results are shown in Table 1.

Note that values indicated in the column of F.F. loss after attachment of interconnector in Table 1 are expressed in relative value (%) based on the assumption that F.F. loss after attachment of the interconnector of the solar cell in comparative example 4 is 100%. In addition, these values of F.F. loss after attachment of the interconnector are average values based on measurement of 2 to 3 solar cells.

### (iii) Tensile Test After Attachment of Interconnector

Adhesive strength and a peel mode between the interconnector attached to the solar cell and the silver electrode on the rear surface of the solar cell in each of examples 1 to 4 and comparative examples 1 to 4 were evaluated by using criteria below, by pulling the interconnector with a tensile testing machine while keeping an angle between the interconnector and a portion of the solar cell other than a portion where the interconnector was attached maintained at 45°. The results are shown in Table 1.

### <Criteria for Determination of Adhesive Strength>

A...Tensile strength by tensile testing machine is not less than 200 g
B... Tensile strength by tensile testing machine is less than 200 g

### <Criteria for Determination of Peel Mode>

In tensile tests with the tensile testing machine stated above, an instance where a crack occurred in the p type silicon substrate while the interconnector and the silver electrode on the rear surface of the p type silicon substrate remained in a good contact state without peeling of the silver electrode from the p type silicon substrate was defined as an A mode. By calculating a ratio of instances in A mode with respect to the number of measurements taken with the tensile tests, evaluations were made by using criteria below.

That is, it is shown that a higher ratio of instances in A mode means a lower possibility of occurrence of peeling at an interface between the silver electrode-the p type silicon substrate, at an interface between the silver electrode-the interconnector, and from within the silver electrode, and higher mechanical strength of the silver electrode itself and higher adhesive strength at the interfaces stated above.
A...Ratio of instances in A mode is 100%
B... Ratio of instances in A mode is not less than 75% but less than 100%
C... Ratio of instances in A mode is not less than 50% but less than 75%
D... Ratio of instances in A mode is less than 50%

**[Table 1]**

| | Blend ratio of silver particles in silver paste (% by mass) | Composition component | Glass softening point of glass component (°C) | Electrical resistance in overlap region of silver electrode-aluininum electrode on rear surface | F.F. loss after attachement of interconnector | Tensile test after attachment of interconnector | |
|---|---|---|---|---|---|---|---|
| | | | | | | Adhesive strength | Peel mode |
| Example 1 | 75% by mass | A | 550 | 75% | 94% | A | A |
| Example 2 | 76% by mass | A | 550 | 26% | 100% | A | A |
| Example 3 | 77% by mass | A | 550 | 45% | 100% | A | A |
| Example 4 | 76% by mass | A | 600 | 14% | 94% | A | B |
| Comparative example 1 | 71% by mass | A | 450 | 246% | 100% | B | D |
| Comparative example 2 | 71% by mass | B | 450 | 185% | 100% | A | D |
| Comparative example 3 | 71% by mass | B | 500 | 148% | 100% | A | D |
| Comparative example 4 | 76% by mass | B | <400 | 100% | 100% | A | B |

As shown in Table 1, the results were such that, in the solar cells in examples 1 to 4 in which the glass softening point temperature of the glass component in the silver paste printed on the rear surface of the p type silicon substrate was equal to or higher than the glass softening point temperature of the glass component in the aluminum paste printed on the same rear surface, all of the electrical resistance in the overlap region of the silver electrode-the aluminum electrode on the rear surface, the F.F. loss after attachment of the interconnector, and the adhesive strength and the peel mode between the interconnector and the silver electrode on the rear surface of the solar cell in the tensile test after attachment of the interconnector were equal to or superior to those in the solar cells in comparative examples 1 to 4 in which the glass softening point temperature of the glass component in the aluminum paste was higher than the glass softening point temperature of the glass component in the silver paste.

It is therefore shown that, when the glass softening point temperature of the glass component in the silver electrode on the rear surface of the solar cell is equal to or higher than the glass softening point temperature of the glass component in the aluminum electrode in each of examples 1 to 4, all of the electrical resistance in the overlap region of the silver electrode-the aluminum electrode on the rear surface, the F.F. loss after attachment of the interconnector, and the adhesive strength and the peel mode between the interconnector and the silver electrode on the rear surface of the solar cell in the tensile test after attachment of the interconnector are superior.

In the solar cell of example 4, for example, the electrical resistance in the overlap region of the silver electrode-the aluminum electrode on the rear surface could be reduced to 14% with respect to that of the solar cell of comparative example 4 by increasing the glass softening point temperature of the glass component in the silver paste to 600°C, without increasing the blend ratio of silver particles.

In the solar cell of example 1, the electrical resistance in the overlap region of the silver electrode-the aluminum electrode on the rear surface could be reduced to 75% with respect to that of the solar cell of comparative example 4 by increasing the glass softening point temperature of the glass component in the silver paste to 550°C, while reducing the blend ratio of silver particles by 1% as compared to the solar cell of comparative example 4.

Electrical characteristics of a solar cell module are now described. In general, a F.F., which is one of the factors that determine electrical characteristics of a solar cell and a solar cell module depends on quantity of electrical resistance, as stated above. Electrical resistance of the entire solar cell module is expressed as a sum of electrical resistance of solar cells after attachment of an interconnector. Accordingly, if an interconnector used for a solar cell module has a length per solar cell which is equal to the length of the interconnector used in the evaluation stated above, electrical resistance of the entire solar cell module depends on quantity of electrical resistance of each solar cell, and a F.F. of a solar cell after attachment of the interconnector substantially corresponds to a F.F. of the entire solar cell module.

In addition, with respect to electrical resistance of a solar cell, if a silver electrode itself on a rear surface has constant electrical resistance due to its small ratio to the rear surface between measurement points of electrical resistance, and if an aluminum electrode and a silver electrode on a light-receiving surface which include the same material have the same electrical resistance, then the difference in electrical resistance between the solar cells results from electrical resistance in the overlap region of the silver electrode-the aluminum electrode on the rear surface shown in the examples and comparative examples stated above. Therefore, a smaller value of the electrical resistance in the overlap region of the silver electrode-the aluminum electrode on the rear surface shown in Table 1 means smaller electrical resistance of the entire solar cell module, and the reduction in F.F. loss after attachment of the interconnector shown in Table 1 owing to the smaller electrical resistance is considered to be reflected in improved electrical characteristics of the entire solar cell module.

In other words, although the electrical characteristics of the solar cell module owing to reduction in electrical resistance in the overlap region of the silver electrode-the aluminum electrode on the rear surface, the adhesive strength between the silver electrode and the interconnector, and the attachability of the interconnector can be improved by increasing the glass softening point temperature of the glass component in the silver paste and by increasing the blend ratio of silver particles in the silver paste, it is preferred that the blend ratio of silver particles in the silver paste be minimized in terms of reduction in manufacturing costs.

Regarding the issue of manufacturing costs, when it is desired to use a silver paste capable of achieving electrical resistance of not more than a prescribed numerical value in an overlap region of a silver electrode-an aluminum electrode as a silver paste used for a silver electrode on a rear surface of a solar cell, a blend ratio of silver powders can be kept low by increasing a glass softening point temperature of a glass component in the silver paste used for forming the silver electrode on the rear surface. Accordingly, the present invention is considered to significantly contribute to reduction in material costs owing to reduction in blend ratio of silver powders in the silver paste.

It should be understood that the embodiments and examples disclosed herein are illustrative and non-restrictive in every respect. The scope of the present invention is defined by the terms of the claims, rather than the description above, and is intended to include any modifications within the scope and meaning equivalent to the terms of the claims.

### INDUSTRIAL APPLICABILITY

According to the present invention, a solar cell capable of achieving excellent electrical characteristics and reliability of a solar cell module while keeping manufacturing costs low and a method of manufacturing the solar cell can be provided.

## Claims

1. A solar cell comprising:
a semiconductor substrate (1) having a pn junction;
a silver electrode (4) and an aluminum electrode (5) on a rear surface of said semiconductor substrate (1); and
an overlap region (9) where said silver electrode (4) and said aluminum electrode (5) overlap each other,
a glass softening point temperature of a glass component contained in said silver electrode (4) being equal to or higher than a glass softening point temperature of a glass component contained in said aluminum electrode (5).

2. A method of manufacturing the solar cell as recited in claim 1, comprising the steps of:
applying a silver paste (4a) acting as a precursor of said silver electrode (4) to said rear surface of said semiconductor substrate (1);
applying an aluminum paste (5a) acting as a precursor of said aluminum electrode (5) to said rear surface of said semiconductor substrate (1); and
firing said silver paste (4a) and said aluminum paste (5a),
a glass softening point temperature of a glass component contained in said silver paste (4a) being equal to or higher than a glass softening point temperature of a glass component contained in said aluminum paste (5a).
